Europäisches Patentamt

European Patent Office

Office européen des brevets

(11) Veröffentlichungsnummer : **0 126 924**
**B1**

# (12) EUROPÄISCHE PATENTSCHRIFT

(45) Veröffentlichungstag der Patentschrift :
19.08.87

(51) Int. Cl.⁴ : **H 05 K 7/18**

(21) Anmeldenummer : 84104022.3

(22) Anmeldetag : 10.04.84

(54) **Baugruppenträger.**

(30) Priorität : 25.04.83 DE 3314871

(43) Veröffentlichungstag der Anmeldung :
05.12.84 Patentblatt 84/49

(45) Bekanntmachung des Hinweises auf die Patenterteilung : 19.08.87 Patentblatt 87/34

(84) Benannte Vertragsstaaten :
**AT CH DE FR GB IT LI NL SE**

(56) Entgegenhaltungen :
**DE-A- 2 750 871**
**GB-A- 1 553 569**
**SIEMENS-ZEITSCHRIFT, Band 46, Nr. 4, 1972, Mün-**
**chen, BRD; R. KELLER et al. "ES 902, Einbausystem**
**für die Industrieelektronik", Seiten 277-288**

(73) Patentinhaber : **Siemens Aktiengesellschaft Berlin**
**und München**
**Wittelsbacherplatz 2**
**D-8000 München 2 (DE)**

(72) Erfinder : **Keller, Roman**
**Grossenbuch 126**
**D-8524 Neunkirchen/Brand (DE)**

## Beschreibung

Die Erfindung betrifft einen Baugruppenträger zur Aufnahme elektronischer Baugruppen, mit zwei Seitenteilen und vier Verbindungsstegen, wobei zur Rückwandverdrahtung eine kaschierte Leiterplatte vorgesehen ist, die an den beiden rückwärtigen Verbindungsstegen mechanisch lösbar befestigt ist.

Baugruppenträger sind aus der Siemens-Zeitschrift 46 (1972), Seiten 277 bis 279 bekannt. Bei dem bekannten Baugruppenträger sind die Seitenteile mit vier Verbindungsstegen an den Ecken verschraubt. In die Rückwand dieser Baugruppenträger sind Feder- oder Messerleisten vielpoliger Steckverbinder eingefügt, deren verdrahtungsseitige Anschlußstifte das Verdrahtungsfeld des Baugruppenträgers bilden. Solche Messer- bzw. Federleisten sind beispielsweise aus der Siemens-Zeitschrift 46 (1972), Seiten 279 und 280 bekannt. Die elektrischen Verbindungen in diesem Verdrahtungsfeld können, wie beispielsweise aus der Siemens-Zeitschrift 46 (1972), Seiten 286 bis 288 bekannt ist, mit diskreter Verdrahtung oder durch eine Leiterplattenverdrahtung hergestellt sein. Die diskrete Verdrahtung wird zunehmend durch die Verdrahtung mit Leiterplatten, den sogenannten Backpanel oder Platter ersetzt. Diese Platter werden überlicherweise mit Schrauben an den Verbindungsstegen des Baugruppenträgers befestigt. Wegen der mechanischen Festigkeit sind die Abstände zwischen den Schrauben relativ klein. Ferner wird die Kupferfläche der Leiterplatte an den Einschraubstellen unterbrochen, was bei der Entflechtung der Leiterplatte zu berücksichtigen ist. Außerdem können durch unterschiedliche Temperaturen während der Fertigung, des Transports und im Betrieb die Abmessungsdifferenzen zwischen Baugruppenträgerrückwand und dem Platter bis über einen Millimeter anwachsen, was bei den geringen Schraubabständen zu hohen mechanischen Spannungen und gegebenenfalls zu Betriebsstörungen führt.

Aus der GB-A-1 553 569 ist ein Gehäuse für elektronische Ausrüstungen bekannt, bei dem die Gehäusewandungen zwischen den beiden Schenkeln von U-förmigen Schienen festgeklemmt sind. Die dem Gehäuse zugewandten Schenkel sind magnetisiert und magnetisch am Gehäuse befestigt. Die Magnetisierung erfordert einen aufwendigen Herstellungsprozess und die Haltbarkeit der Verbindung ist für die Kräfte, die beim Einschieben und Lösen der Baugruppen auftreten nicht ausreichend.

Es besteht die Aufgabe, einen Baugruppenträger der eingangs genannten Art so auszuführen, daß die lösbare Verbindung zwischen dem Platter und dem Baugruppenträger ohne besonderen personellen Aufwand bewerkstelligt werden kann, wobei gleichzeitig Funktionsstörungen für die Leiterplatte zu vermeiden sind.

Erfindungsgemäß wird diese Aufgabe dadurch gelöst, daß zur lösbaren Befestigung wenigstens ein U-förmiges Kunststoffteil mit einem federnd ausgebildeten Schenkel vorgesehen ist, von dessen anderem, am Verbindungssteg anliegenden Schenkel ein federnd ausgebildeter Steg absteht, der mit einer Rastnase versehen ist, die eine Kante des Verbindungssteges hintergreift und daß die Leiterplatte zwischen beiden Schenkeln eingeklemmt ist.

Bei dem erfindungsgemäßen Baugruppenträger kann der Platter schnell an der Rückwand montiert und gegebenenfalls für Wartungsarbeiten auch wieder demontiert werden. Dabei bleiben die Kupferflächen der Leiterplatte unbeeinflußt und mechanische Spannungen bei unterschiedlichen Temperaturen treten nicht auf. Es kann ein extrudiertes Kunststoffteil verwendet werden, das leicht und billig zu fertigen ist. Der Platter ist mit diesem Kunststoffteil kraftschlüssig verbunden, da er zwischen den Schenkeln des U-förmigen Profils verkeilt ist. Dabei ist eine seitliche Bewegung zum Ausgleich von Wärmespannungen möglich, da der Platter in das U-Profil eingeschoben ist. Mit der formschlüssigen Verbindung wird nicht nur die Montage erleichtert, sondern es werden auch Luft- und Kriechstrecken vermieden, die bei einer Verschraubung der Halteschienen am Verbindungssteg wegen geringer Schraubabstände auftreten könnten. Zur Montage wir die Halteschiene lediglich auf den Verbindungssteg aufgeschnappt und für Wartungsarbeiten läßt sich die Halteschiene leicht vom Verbindungssteg entfernen. Darüber hinaus werden durch den Steg die Luft- und Kriechstrecken zwischen den Leiterbahnen des Platters und dem Verbindungssteg verlängert.

Vorzugsweise erstreckt sich das Kunststoffteil als Halteschiene über die gesamte Länge des Verbindungsstegs. Damit wird nicht nur die mechanische Festigkeit der Verbindung zwischen dem Platter und dem Baugruppenträger optimiert, sondern es wird auch die Einhaltung von erforderlichen Luft- und Kriechstrecken erleichtert.

Um die Festigkeit der Verbindung zu erhöhen, kann der federnd ausgebildete Schenkel des Kunststoffteils an seiner der Leiterplatte zugewandten Seite mit Ansätzen versehen sein, die formschlüssig in Ausformungen der Leiterplatten eingreifen.

Der am Verbindungssteg anliegende Schenkel kann im Berührungsbereich mit dem Verbindungssteg einen Ansatz besitzen, der formschlüssig in eine Ausformung des Verbindungssteges eingreift. Dieser Ansatz dient als Widerlager in der Verriegelung der Halteschiene und erstreckt sich vorteilhaft über die gesamte Länge des Kunststoffteils.

Zur Stromversorgung können Metallteile in die der Leiterplatte zugewandten Seite wenigstens eines der Schenkel eingefügt und an Leiterbahnen der eingeklemmten Leiterplatte angepreßt sein. Bei dieser Ausführungsform wird der Platter nicht nur in einfacher Weise am Baugruppenträger gehalten, sondern er dient gleichzeitig zur Stromversorgung der in den Baugruppenträger eingeschobenen Baugruppen.

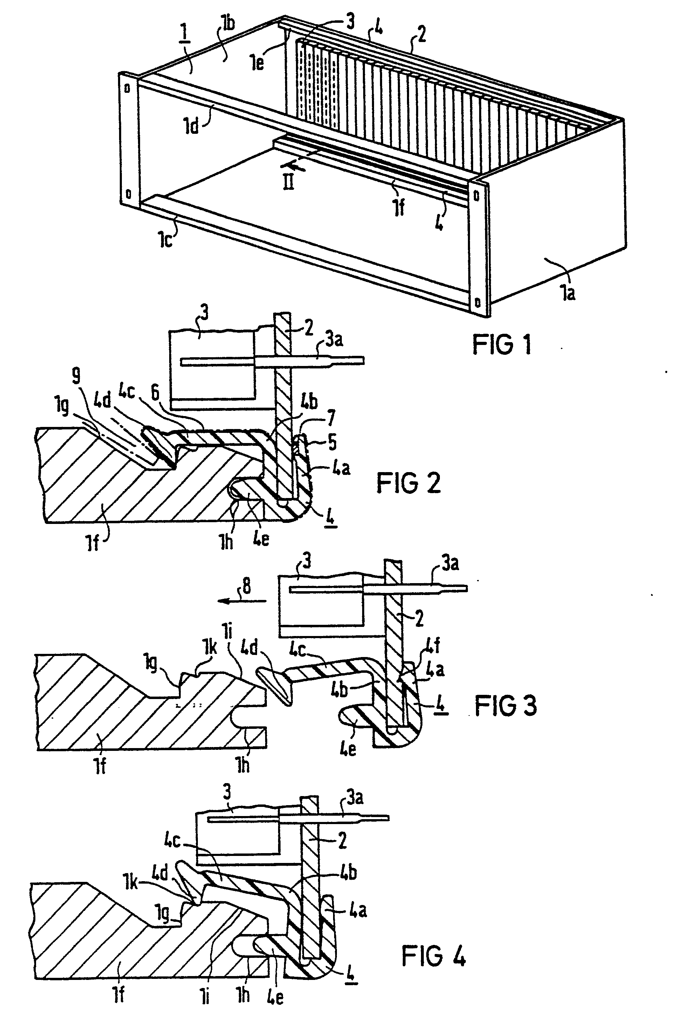

Im folgenden wird der erfindungsgemäße Baugruppenträger beispielhaft anhand der Figuren 1 bis 4 näher erläutert, wobei gleiche Bauteile mit dem gleichen Bezugszeichen versehen sind.

Figur 1 zeigt einen erfindungsgemäß ausgestalteten Baugrupenträger 1 in perspektivischer Ansicht. Die Seitenfläche 1a und 1b sind mit den Querstegen bzw. Querschienen 1c und 1d, 1e und 1f verbunden. Als Rückwandverdrahtung ist eine kaschierte Leiterplatte, ein sogenannter Platter 2 vorgesehen, in dem beim Ausführungsbeispiel die Messer- bzw. Federleisten 3 eines vielpoligen Steckverbinders zum indirekten Stecken gedruckter Schaltungen befestigt sind und vom Platter 2 getragen werden. Die Messer- bzw. Federleisten 3 der vielpoligen Steckverbinder sind in der Figur nur schematisch angedeutet. Bei solchen handelsüblichen Baugruppenträgern ist der Platter 2 an den Verbindungsstegen 1e und 1f verschraubt. Die Nachteile dieser Befestigung, nämlich geringe Schraubenabstände wegen der erforderlichen mechanischen Festigkeit und damit Schwierigkeiten bei der Einhaltung der notwendigen Luft- und Kriechstrecken, Unterbrechungen der Kupferkaschierung des Platters im Schraubenbereich und gegebenenfalls Funktionsstörungen aufgrund von Wärmespannungen wurden bereits ausführlich erläutert. Zur Vermeidung dieser Nachteile ist beim Baugruppenträger nach Figur 1 der Platter 2 mit aus Kunststoff hergestellten Halteschienen 4 an den Verbindungsstegen 1e und 1f festgeklemmt.

Figur 2 zeigt einen Schnitt längs der Linie II-II der Figur 1. Am Platter 2 ist der Steckverbinder 3 befestigt, Anschlußstifte 3a ragen aus der Rückwand des Platters 2 heraus und bilden ein zusätzliches Verdrahtungsfeld des Baugruppenträgers 1. Der Platter 2 ist mit einer Halteschiene 4 am Verbindungssteg 1f des Baugruppenträgers 1 verriegelt. Die Halteschiene 4 besitzt U-förmiges Profil. Ein Schenkel 4a liegt am Verbindungssteg 1f an. Der zweite Schenkel 4b ist elatisch ausgebildet und dient als Kraftspeicher. Die Halteschiene 4 ist ein extrudiertes Kunststoffteil. Der Platter 2 wird zwischen die beiden Schenkel 4a und 4b eingeschoben und ist mit diesem Kunststoffteil kraftschlüssig verbunden. Die Halteschiene 4 ist an dem Verbindungssteg 1f formschlüssig befestigt. Hierzu ist sie mit einem federnd ausgebildeten Steg 4c versehen, der am Ende des Schenkels 4a absteht. Der Steg 4c besitzt eine Rastnase 4d, die den Verbindungssteg 1f hintergreift und den Schenkel 4a an den Verbindungssteg 1f anpreßt. Im Ausführungsbeispiel hintergreift die Rastnase 4d den Verbindungssteg 1f in einer Nut 1g des Verbindungssteges. Zusätzlich greift ein am Schenkel 4a angeformter Ansatz 4e formschlüssig in eine Ausformung 1h in der Verbindungsschiene 1f ein. Die sich vorzugsweise über die gesamte Länge des Kunststoffteiles 4 erstreckende Ausformung 4e verhindert eine Verschiebung der Halteschiene 4 in der Zeichenebene und dient als zusätzliches Widerlager für die formschlüssige Verbindung mittels der Rastnase 4d, so daß das Kunststoffteil 4 am Verbindungssteg 1f verriegelt ist.

Im Ausführungsbeispiel ist das Kunststoffteil 4 als Schiene ausgebildet, die sich über die gesamte Länge des Platters 2 und der Verbindungsstege 1f bzw. 1e erstreckt. Für die Befestigung des Platters 2 kann es ausreichend sein, lediglich ein oder zwei kürzere Kunststoffteile 4 an jeder Verbindungsschiene 1f bzw. 1e zu verriegeln. Die mechanische Befestigung des Platters 2 wird selbstverständlich in einer Halteschiene 4 erhöht, die entsprechend dem Ausführungsbeispiel den Platter 2 über seine gesamte Länge abstützt. Mit einer solchen Halteschiene 4 ist außerdem die Kupferkaschierung des Platters 2 ausreichend gegen die Verbindungsschiene 1f isoliert. In Figur 2 sind mit strichpunktierten Linien die Luft- und Kriechstrecken eingezeichnet, die man mit der gezeigten Ausführungsform erhält und die für die elektrische Isolierung des Platters 2 ausreichend sind. Da der Platter 2 in dem Kunststoffteil 4 eingeschoben ist, braucht er mechanisch nicht verändert zu werden. Dies bedeutet insbesondere, daß keine Bohrungen im Platter vorgesehen werden müssen. Die bohrungsfreien Flächen können daher zusätzlich mit Leiterbahnen versehen sein, die beispielsweise zur Stromversorgung der Baugruppen herangezogen werden können. Im Ausführungsbeispiel nach Figur 2 ist für solche Leiterbahnen eine Stromzuführung über die Kunststoffschiene 4 vorgesehen. In den federnd ausgebildeten Schenkel 4b sind Metallteile 7 eingefügt, die jeweils an eine Leiterbahn des Platters 2 angepreßt ist. Über solche Metallteile 7, die unmittelbar auf angeäzten Leiterbahnen innerhalb der gedruckten Schaltung des Platters kontaktiert sind, kann Versorgungsstrom zugeführt werden. Der elektrische Anschluß an solche eingepreßten Metallteile 7 kann beispielsweise über Bohrungen im Kunststoffschenkel 4b erfolgen. Zu erwähnen ist noch, daß der Platter 2 in Richtung senkrecht zur Zeichnungsebene sich ausdehnen kann, so daß der Ausgleich von Wärmespannungen sichergestellt ist.

Figur 3 und 4 demonstrieren die einfache Montage des Platters 2 am Baugruppenträger 1. Dabei entspricht der Schnitt nach Figur 3 und 4 dem Schnitt nach Figur 2. In Figur 3 ist der Platter 2 zur Montage im Baugruppenträger 1 vorbereitet, d. h. er ist mit seinen beiden Längsseiten in Halteschienen 4 eingeschoben. Der Platter 2 wird dann in Richtung des Pfeiles 8 in die Rückwand des Baugruppenträgers 1 eingeschoben. Wegen der schrägen Anlaufkanten der Rastnasen 4d wird der federnde Steg 4c nach oben gebogen und die Rastnase schiebt sich über die Anlauffläche des Verbindungssteges, bis sie in die Nut 1g einrastet. Dieses Einschieben kann durch eine schräge Anlauffläche 1i der Verbindungsstege 1e bzw. 1f noch erleichtert werden. Im Ausführungsbeispiel nach Figur 4 ist eine weitere Ausführungsform gezeigt, bei der der Verbindungssteg 1f eine zusätzliche, klei-

ne Nut 1k besitzt. In diese Nut 1k schnappt die Rastnase 4d für eine Montage- bzw. Demontagezwischenstellung ein. Die Figur zeigt weiterhin, wie sich der Platter im U-förmigen Profil der Halteschiene während des Einschiebens bewegt. Daraus ist ersichtlich, daß eine mechanische Beschädigung des Platters während der Montage oder der Demontage nicht zu befürchten ist.

Zur Demontage des Platters ist lediglich die Rastnase 4d aus ihrer Verriegelungsstellung zu entfernen. Dies kann, wie in Figur 2 angedeutet ist, mittels eines Schraubendrehers 9 erfolgen, mit dem die Rastnase nach oben gedrückt wird. Speziell für die Demontage ist die mit der zusätzlichen Nut 1k erhaltene Zwischenstellung interessant, da in dieser Zwischenstellung der Platter 2 gehalten wird und damit die Demontage des Platters 2 von einem Mann ausgeführt werden kann.

Eine weitere Abwandlung ist in Figur 3 gezeigt, wo der federnd ausgebildete Schenkel 4a des Kunststoffteils 4 mit einer sägezahnförmigen Noppe 4f versehen ist, die in eine entsprechende Ausformung des Platters 2 formschlüssig eingreift und die kraftschlüssige Verbindung zwischen Platter 2 und Halteschiene 4 noch verbessert. Nachteilig ist bei dieser Ausführungsform jedoch, daß die Oberfläche des Platters mit Ausformungen versehen sein muß, was gegebenenfalls die Kupferkaschierung unterbricht.

## Patentansprüche

1. Baugruppenträger zur Aufnahme elektronischer Baugruppen, mit zwei Seitenteilen und vier Verbindungsstegen, wobei zur Rückwandverdrahtung eine Leiterplatte vorgesehen ist, die an den beiden rückwärtigen Verbindungsstegen mechanisch lösbar befestigt ist, dadurch gekennzeichnet, daß zur lösbaren Befestigung wenigstens ein U-förmiges Kunststoffteil (4) mit einem federnd ausgebildeten Schenkel (4a) vorgesehen ist, von dessen anderem, am Verbindungssteg (1e, 1f) anliegenden Schenkel (4b) ein federnd ausgebildeter Steg (4c) absteht, der mit einer Rastnase (4d) versehen ist, die eine Kante (1g) des Verbindungssteges hintergreift und daß die Leiterplatte (2) zwischen beiden Schenkeln eingeklemmt ist.

2. Baugruppenträger nach Anspruch 1, dadurch gekennzeichnet, daß sich das Kunststoffteil (4) als Halteschiene über die gesamte Länge des Verbindungssteges (1e, 1f) erstreckt.

3. Baugruppenträger nach einem der Ansprüche 1 oder 2, dadurch gekennzeichnet, daß der federnd ausgebildete Schenkel (4a) an seiner der Leiterplatte (2) zugewandten Seite mit Ansätzen (4f) versehen ist, die formschlüssig in Ausformungen der Leiterplatte (2) eingreifen.

4. Baugruppenträger nach einem der Ansprüche 1 bis 3, dadurch gekennzeichnet, daß der am Verbindungssteg (1e, 1f) anliegende Schenkel (4b) im Berührungsbereich mit dem Verbindungssteg einen Ansatz (4e) besitzt, der formschlüssig in eine Ausformung (1h) des Verbindungssteges (1e, 1f) eingreift.

5. Baugruppenträger nach Anspruch 4, dadurch gekennzeichnet, daß der Ansatz (4e) sich schienenförmig über die gesamte Länge des Kunststoffteils (4) erstreckt.

6. Baugruppenträger nach einem der Ansprüche 1 bis 5, dadurch gekennzeichnet, daß Metallteile (5) in die der Leiterplatte (2) zugewandten Seite wenigstens eines der Schenkel (4a, 4b) eingefügt und an die eingeklemmte Leiterplatte (2) angepreßt sind.

## Claims

1. An assembly carrier for the accommodation of electronic assemblies, comprising two side components and four connecting cross-members, where, for the rear-wall wiring, a circuit board is provided which is fixed to the two rear connecting cross-members so as to be mechanically detachable, characterised in that for the detachable fixing of the circuit board at least one U-shaped synthetic component (4) is provided which has a resilient flank (4a) and from whose other flank (4b), which abuts against the connected cross-member (1e, 1f), there projects a resilient cross-member (4c) which is provided with an engaging lug (4d) which engages behind an edge (1g) of the connecting cross-member, and that the circuit board (2) is clamped between the two flanks.

2. An assembly carrier as claimed in claim 1, characterised in that the synthetic component (4) extends in the form of a supporting rail along the entire length of the connecting cross-member (1e, 1f).

3. An assembly carrier as claimed in one of the claims 1 or 2, characterised in that on its side facing towards the circuit board (2) the flexible flank (4a) is provided with projections (4f) which engage in shape-locking fashion into openings in the circuit board (2).

4. An assembly carrier as claimed in one of the claims 1 to 3, characterised in that the flank (4b) which abuts against the cross-member (1e, 1f) is provided, in its contact zone with the connecting cross-member, with a projection (4c) which engages in shape-locking fashion into an opening (1h) of the connecting cross-member (1e, 1f).

5. An assembly carrier as claimed in claim 4, characterised in that the projection (4e) extends in the form of a rail along the entire length of the synthetic component (4).

6. An assembly carrier as claimed in one of the claims 1 to 5, characterised in that metal components (7) are inserted into the side of at least one of the flanks (4a, 4b) facing towards the circuit board (2) and are pressed against the clamped circuit board (2).

## Revendications

1. Porte-modules destiné à recevoir des modules électroniques, comportant deux parois latérales et quatre barrettes de liaison, et dans lequel il est prévu, pour le câblage de la paroi arrière, une plaquette à circuits imprimés qui est fixée d'une manière détachable mécaniquement aux deux barrettes de liaison arrière, caractérisé par le fait que pour réaliser la fixation détachable, il est prévu au moins une pièce en matière plastique (4) en forme de U, comportant une branche (4a) agencée de manière à être élastique, tandis qu'à partir de l'autre branche (4b) de la pièce en matière plastique, qui est appliquée contre la barrette de liaison (1e, 1f), fait saillie une barrette (4c) agencée de manière à être élastique et qui est munie d'un bec d'encliquetage (4d) qui s'engage derrière un bord (1c) de la barrette de liaison et que la plaquette à circuits imprimés (2) est bloquée par serrage entre les deux branches.

2. Porte-modules suivant la revendication 1, caractérisé par le fait que la pièce en matière plastique (4) s'étend, sous la forme d'un rail de retenue, sur toute la longueur de la barrette de liaison (1e, 1f).

3. Porte-modules suivant l'une des revendications 1 ou 2, caractérisé par le fait que la branche (4a) agencée de manière à être élastique comporte, sur sa face tournée vers la plaquette à circuits imprimés (2), des appendices saillants (4f) qui s'engagent, selon une liaison par formes complémentaires, dans des évidements façonnés dans la plaquette à circuits imprimés (2).

4. Porte-modules suivant l'une des revendications 1 à 3, caractérisé par le fait que la branche (4b) appliquée contre la barrette de liaison (1e, 1f) possède, dans la zone de contact avec la barrette de liaison, un appendice saillant (4e), qui s'engage, selon une liaison par formes complémentaires, dans un évidement (1h) façonné dans la barrette de liaison (1e, 1f).

5. Porte-modules suivant la revendication 4, caractérisé par le fait que l'appendice saillant (4e) s'étend à la manière d'un rail sur toute la longueur de la pièce en matière plastique (4).

6. Porte-modules suivant l'une des revendications 1 à 5, caractérisé par le fait que des pièces métalliques (5) sont insérées dans la face, tournée vers la plaquette à circuits imprimés (2), d'au moins l'une des branches (4a, 4b) et sont repoussées contre la plaquette à circuits imprimés (2) bloquée par serrage.

FIG 1

FIG 2

FIG 3

FIG 4